Europäisches Patentamt

European Patent Office

Office européen des brevets

(11) Publication number: **0 119 059**
**B1**

# EUROPEAN PATENT SPECIFICATION

(45) Date of publication of patent specification: **05.10.88**

(21) Application number: **84301523.1**

(22) Date of filing: **07.03.84**

(51) Int. Cl.⁴: **H 01 L 27/02**

(54) Semiconductor integrated circuit with gate-array arrangement.

(30) Priority: **09.03.83 JP 38483/83**
**08.12.83 JP 231881/83**

(43) Date of publication of application:
**19.09.84 Bulletin 84/38**

(45) Publication of the grant of the patent:
**05.10.88 Bulletin 88/40**

(84) Designated Contracting States:
**DE FR GB**

(56) References cited:
**EP-A-0 005 723**

**JAPANESE JOURNAL OF APPLIED PHYSICS,**
**vol. 19, suppl. 19-1, 1980, pages 203-206,**
**Tokyo, JP; M. ASHIDA et al.: "A 3000-gate**
**CMOS masterslice LSI"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Hara, Hisashi**
**2-1-2, Kajiwara**
**Kamakura-shi Kanagawa-ken (JP)**

(74) Representative: **Freed, Arthur Woolf et al**
**MARKS & CLERK 57-60 Lincoln's Inn Fields**
**London WC2A 3LS (GB)**

## Description

The present invention relates in general to a semiconductor integrated circuit to be manufactured in accordance with a master slice method and, more particularly, to a semiconductor IC device which constitutes a gate-array using the fundamental cells of the CMOS structure.

Recently, the semiconductor integrated circuit (IC) device, particularly the LSI device technology, has remarkably advanced, as have the large scale integration of logic LSIs which are typically represented by a memory or a microprocessor. Thus, various kinds of electronic equipment and electronic systems are constituted as more and more LSIs are used. The LSIs have improved performance, lowered the price, lightened the weight, decreased the size, and have improved the reliability of equipment. In making LSIs for various equipment and systems, in addition to making microchips with a memory and a processor or the like, the demand for LSIs having specialized electronic circuits having the functions peculiar to the various equipment and systems is on the increase. In general, it is difficult to make a made-to-order LSI because of the manufacturing cost. As is well known, the cost of semiconductor devices, particularly LSIs, can only be reduced by mass production. If only a few circuits which are used in only one particular electronic system are constructed as an LSI, the cost of this dedicated LSI will naturally be high, thereby contradicting the intended purpose of the LSI, to lower manufacturing costs. For semiconductor manufacturers, making LSIs whose portions are peculiar to specialized equipment and systems obviously means that although a large variety of LSIs are manufactured, only a small amount of each variety can be made. Therefore, great amount of development costs which are needed for developing a wide variety of LSIs is born by only a small quantity of LSIs. The result is that the cost of the dedicated LSIs is prohibitive.

To solve the above-mentioned manufacturing problem, the gate-array device structure by way of a so-called master slice method has been theorized. As is well-known to those skilled in the art, a manufacturing method of these gate-array devices generally includes a master step and a personalizing step. Although gate-arrays are semi-manufactured goods in the master step, it is possible to produce a great amount of master chips as so-called general purpose goods. On the other hand, in the personalizing step, it is possible to realize a logical circuit which meets the requirements of a customer for a short design interval using a CAD system. Therefore, this method is highlighted as the method whereby the dedicated LSIs for use in specialized electronic equipment systems can be supplied quickly and cheaply.

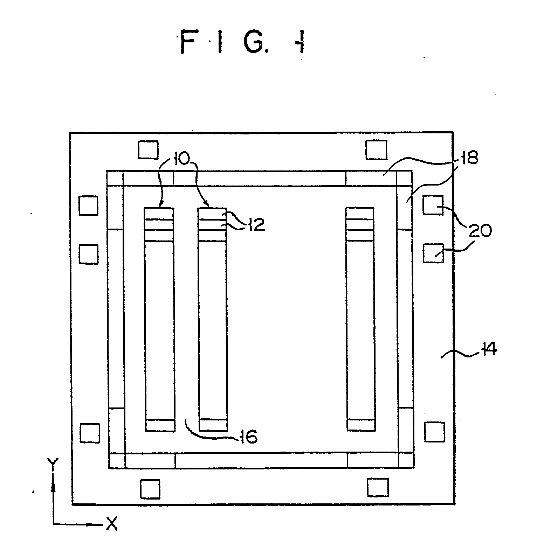

However, even if such a useful gate-array technology was applied, there are still various problems in the way of lowering the cost of highly integrated LSI devices. The first problem relates to the limited improvements that can be made in integrating power. According to the present gate-array structure as shown in Fig. 1, fundamental cell arrays 10 each consisting of a plurality of fundamental cells 12 which in turn includes a predetermined number of MOS transistors are formed to define a predetermined dedicated wiring region 16 on a substrate 14 by the above-mentioned master step. A reference numeral 18 denotes the well-known input/output cells, and 20 indicates the bonding pads. A wiring region 16 is formed containing wiring patterns (not shown) which are necessary to desirably connect with the macrocells which in turn consist of at least one fundamental cell 12. Therefore, it is inhibited to form a fundamental cell in the region 16 on the substrate 14. In other words, it can be said that the wiring region 16 is inherently dead space (vain surface region) with respect to the formation of the fundamental cells 12. As shown in Fig. 1, in a conventional gate-array, the area of the portion of the fundamental cell array 10 is substantially equal to that of the wiring region 16, while the area to be occupied by the wiring portion in one LSI is extremely large. In addition, the devices in the fundamental cell are also large. This is because of the following reasons. In ordinary logic LSIs, transistors having various sizes are used based on the characteristics which decrease the area of a chip. On the contrary, in gate-arrays, it is necessary that the transistors in the fundamental cell have the same dimensions, so that an intermediate size is adopted. The scale of the gate array is suppressed to about 1/5 of that of an ordinary logic LSI, since the area of both the wiring portion and the transistors is large. As described above, gate-arrays having the scale as requested by some customers can not be satisfactorily realized at the present time due to the limitation of the technology. Also, to obtain a large scale gate-array, it is particularly important to constitute the cell array section, including the wiring regions, with a high degree of density.

Furthermore, another problem in the present gate-array structure as shown in Fig. 1 is that it is impossible to efficiently use the fundamental cells when manufacturing a LSI having a dsesired logical function. Conventionally, in the case where it is necessary to connect two fundamental cells (each of which has a plurality of MOS transistors) to combine one macrocell for example, predetermined connections and wirings are performed between the two fundamental cells which are linearly arranged in the direction along the longitudinal direction of the same cell array. It is impossible to constitute one macrocell by connecting the fundamental cells which are respectively included in the adjacent two cell arrays. This is because of the above-mentioned dedicated wiring region which exists between the adjacent two cells. If the connection wiring in the macrocell is formed in this region, it will interfere with the formation of the connection wiring pattern between the macrocells. Even if any excess MOS transistors are remaining in the fundamental cell after one macrocell is constituted, these excess MOS transistors in the same cell array can not be effectively used to constitute other macrocells. Consequently, it is impossible to expect the effective usage of the MOS transistors in the case of designing a desired LSI using a gate-array since some useless MOS transistors remain in the MOS transistors which constitute the fundamental cell.

It is therefore an object of the present invention to provide a new and improved CMOS integrated circuit device with a gate-array arrangement, which device is manufactured to have a high integration power in accordance with a master slice method and which can effectively use transistor devices in a gate-array without waste in order to realize an integrated circuit having a predetermined logical function.

According to a CMOS gate-array type integrated circuit device of the present invention, there is formed a plurality of cell arrays which exist along the first direction on a semiconductive substrate of a first conductivity type and in which neighboring fundamental cell arrays are arbitrarily coupled. Each cell array of the above-mentioned plurality of cell arrays includes a plurality of fundamental cells each of which includes at least two mutually complementary MOS-type transistors which are adjacent along a second direction substantially perpendicular to the first direction. Two MOS-type transistors having the same channel type and being in contact with each other in the second direction belong to two adjacent but different fundamental cell arrays which exist in the above-mentioned plurality of cell arrays. A semiconductive well region of a second conductivity type is formed on the surface portion of the substrate as a well region which is commonly used for the two MOS-transistors having the same channel type. Electrical connection wiring layers are then stacked over those plurality of fundamental cell arrays to form an integrated circuit having a desired function. This is done by adding predetermined connection wirings to the above-mentioned fundamental cells which are included in a plurality of fundamental cell arrays. These electrical connection wiring layers form a plurality of macrocells each of which serves as a unit component element of the above-mentioned integrated circuit which has a desired function. The plurality of macrocells includes at least one macrocell which has a particular logical function and which includes at least two fundamental cells which respectively are included in the mutually neighboring fundamental cell arrays, are adjacent to each other along the second direction, and are directly coupled.

The present invention is best understood by reference to the accompanying drawings, in which:

Fig. 1 is a diagram showing a plane constitution of a master chip having a conventional gate-array arrangement;

Fig. 2 is a diagram showing a plane constitution of a gate-array semiconductor integrated circuit as one embodiment of the present invention;

Fig. 3 is a diagram showing an enlarged partial plane constitution of cell arrays which are included in the gate-array of Fig. 2 and which come into contact with each other;

Fig. 4 is an enlarged plan view showing the two fundamental cells of Fig. 1 to show a plan constitution of a plurality of MOSFETs which is included in the fundamental cell;

Fig. 5 is a cross-sectional view taken along the line X-X of the fundamental cell structure of Fig. 4;

Fig. 6 is a diagram showing an equivalent circuit of one macrocell serving as a two-input NOR gate which is obtained by performing a suitable wiring processing for the above two fundamental cells;

Fig. 7 is a model plan arrangement diagram of MOSFETs showing the remaining unused MOSFETs in the two fundamental cells when the macrocell of Fig. 6 was made;

Fig. 8 is a model plan arrangement diagram showing has another macrocell serving as a two-input NAND gate was formed in the fundamental cell at the next stage of the fundamental cells of Fig. 7; and

Figs. 9 to 11 are partial fundamental cell arrangement diagrams schematically showing other wiring examples of power supply lines, respectively.

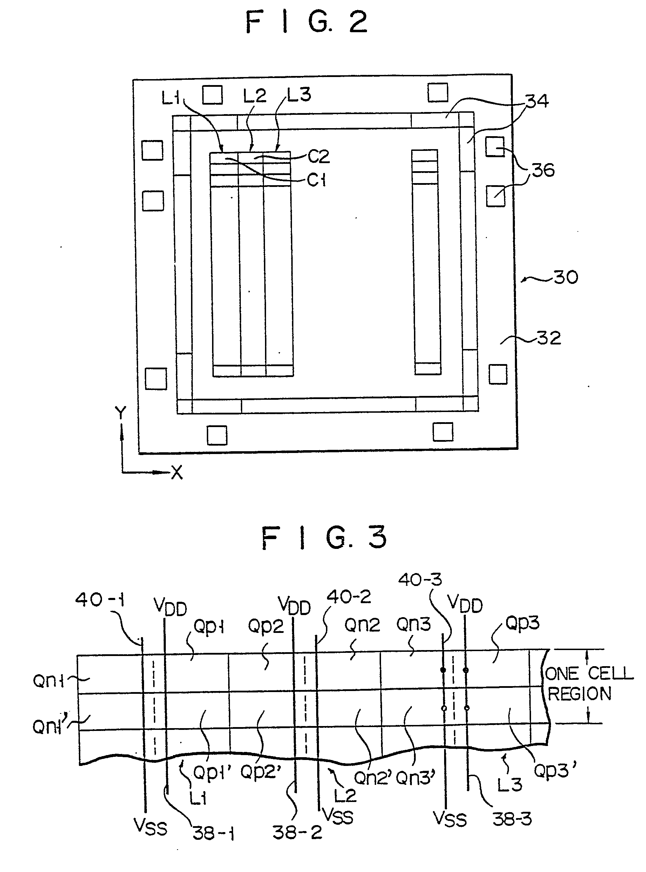

Fig. 2 shows a plan view of a semiconductor IC device 30 as one embodiment of the present invention.

This general purpose IC device 30 is a semiconductor chip (master chip) which is obtained after the completion of a master step as part of the gate-array process according to the master slice method. A plurality of linear fundamental cell arrays L1, L2, L3, ... is formed on the surface of the central portion of a substrate 32 of this chip so as to be adjacent to each other. No wiring region for wires necessary to transform a general purpose IC circuit into a dedicated one is provided between the two adjacent cell arrays. Each cell array L consists of a plurality of fundamental cells C which has a CMOS structure. In addition, I/O cells 34, which simultaneously constitute an input circuit to receive input signals from the outside and an output circuit to transmit output signals to the outside, are formed and arranged in a square around the chip so as to surround the cell arrays L. Furthermore, bonding pads 36 are formed and arranged the outside of the chip.

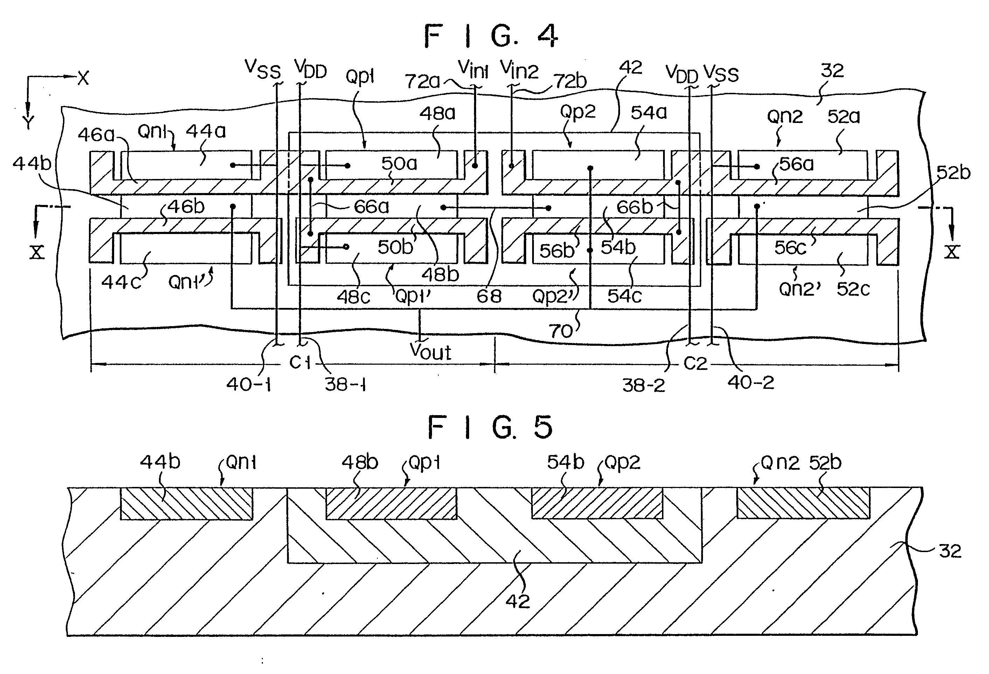

The part of the cell arrays L of Fig. 1 is enlargedly illustrated in Fig. 3. Each of the fundamental cells C1, C2 or C3 has four MOSFETs, i.e., two p-channel MOSFETs Qp and two n-channel MOSFETs Qn. In the fundamental CMOS cells which are respectively included in the different cell arrays and which are adjacent to each other in the row direction, the arrangements of the p- and n-channel MOSFETs Qp and Qn along the row direction (perpendicular to the direction where the cell arrays exist) X are set to be opposite to each other. For example, in the CMOS cell C1 which is included in the first cell array L1, the n-channel FET Qnl and the p-channel FET Qpl are sequentially disposed along the row direction (the other cells in the first cell array L1 also have a similar arrangement). On the other hand, in the cell C2 which is included in the second cell array L2 and which is adjacent to the above cell C1, the p- and n-channel FETs Qp2 and Qn2 are sequentially arranged in the same row direction in the manner opposite to above-mentioned arrangement (the other cells in the cell array L2 are also similarly arranged). Therefore, the MOSFETs of the same channel type (p-channel FETs or n-channel FETs) are symmetrically arranged at the adjacent boundary portion of these cells C1 and C2. That is, two kinds of power supply lines 38 and 40 are formed over the cell arrays so as to be elongated along the existing direction of the cell arrays near the boundary (indicated by the broken lines in Fig. 4) between the n-channel device region and the p-channel device region of the CMOS fundamental cell of the same cell array. Each of the power supply lines 38 and 40 comes into electrical contact with a predetermined layer of the fundamental cells near the above-mentioned boundary portion. In other words, the two kinds of power supply lines 38 ans 40 which are common to each. cell array L are stacked at the upper central portion of each cell array L.

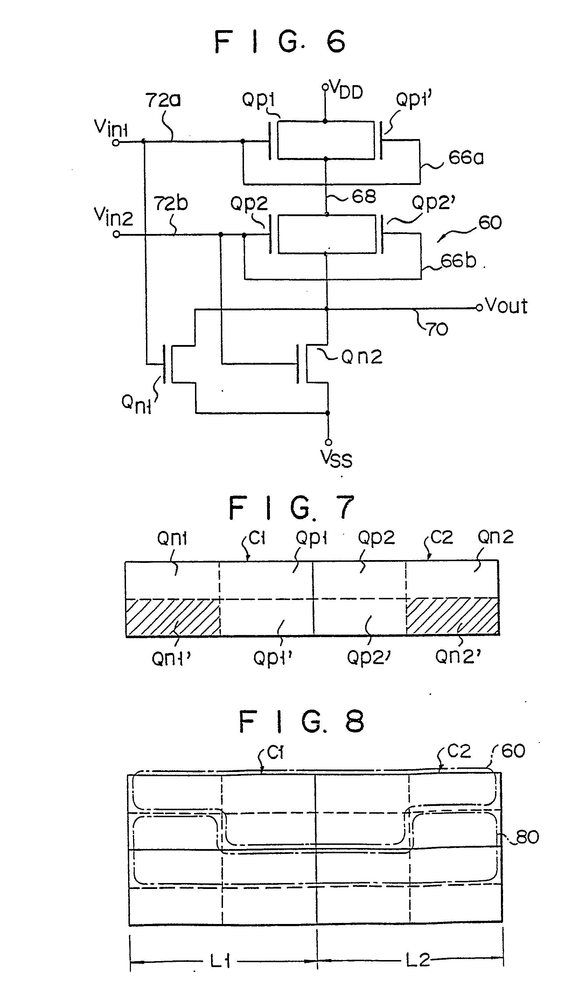

To show the internal structure of each fundamental cell more clearly, the plan view of the two fundamental cells C1 and C2 of Fig. 4 are shown in greater detail in Fig. 4. Fig. 5 shows a cross-sectional view taken along the line X-X of the fundamental cell structure of Fig. 4. In Fig. 4, the silicon substrate 32 has, for example, a p-conductivity. One fundamental cell Cl consists of two n-channel MOSFETs Qn1 and Qn1' to be formed on the substrate 32 and two p-channel MOSFETs Qp1 and Qp1' to be provided in an n-conductivity type well region 42 formed in the surface portion of the substrate 32. Namely, to form the n-channel MOSFETs Qn1 and Qn1', three $n^+$ diffusion layers 44a, 44b and 44c are formed along the Y direction in the substrate 32. At the same time two gate electrodes 46a and 46b are formed on these $n^+$ layers 44 by being self-aligned in the well-known manner. In the cell C1, to further form the two p-channel MOSFETs Qp1 and Qp1', three $p^+$ diffusion layers 48a, 48b and 48c are formed along the Y direction in the above-mentioned n-well region 42. Gate electrodes 50a and 50b are also added. As shown in Fig. 4, the gate electrodes 46a and 50a are integrally formed. These gate electrodes 46 and 50 are simultaneously made by the well-known patterning forming technology so as to have the plane shape of Fig. 4. The gate electrodes 46 and 50 consist of polycrystalline silicon. The other fundamental cell C2 which is adjacent to this cell C1 in the X direction similarly has: the two n-channel FETs Qn2 and Qn2'; the two p-channel FETs Qp2 and Qp2' which are created by $n^+$ layers 52a, 52b and 52c to be formed in the substrate 32, $p^+$ layers 54a, 54b and 54c to be formed in the n-well region 42; and the gate electrodes 56a, 56b and 56c having the plane pattern shown in the drawing. It should be noted that the p-channel MOSFETs Qp1 and Qp2 (or Qn2' and Qn3') which are respectively included in the adjacent cells C1 and C2 are formed in the same n-well region 42. In other words, the p-channel MOSFETs Qp1 and Qp2 (or Qp1' and Qp2') which are respectively included in the adjacent cells C1 and C2 share a single n-well 42, where at the same time the four p-channel MOSFETs Qp1, Qpl', Qp2, and Qp2' are simultaneously arranged.

The process of remaking an LSI circuit using a semiconductor wafer which has completed the master step by providing metal wirings on the wafer requires a personalizing step. In gate-arrays, the manufacturing interval after an order from a customer is received, corresponds to only this personalizing step, in order to allow the LSI development interval to be shortened. As before, it is again important that the design interval be short. The following is a method adopted for this purpose. Various kinds of gates (e.g., there are 50 - 150 kinds of fundamental circuits such as an NOR, NAND, flip-flop, etc.) which are necessary to constitute a logical circuit using the above-described fundamental cells are designed and stored in the form of data as a library might be stored in a computer. In case of manufacturing a gate-array, the prepared gate is called a macrocell. Once the requirements of a customer are determined, the whole circuit is designed using the macrocells which are automatically arranged using the CAD system. Thereafter only the wiring of the macrocells needs to be done. In this way the function that is required by the customer can be designed, and the design interval can be shortened.

A plurality of fundamental cells is ordinarily used to form a macrocell. One macrocell can be formed using fundamental cells which are included in the two neighboring cell arrays and which are adjacent to each other in the X direction. A wiring example in which a two-input NOR gate serves as one macrocell was designed using two fundamental cells C1 and C2 (having the CMOS structure shown in Fig. 2) is illustrated by the thick solid lines in Fig. 4. In addition, Fig. 6 shows the equivalent circuit of the portions of the fundamental cells C1 and C2 after the connection wirings in the macrocell were done as shown in Fig. 4.

A two-input NOR gate 60 represented by the equivalent circuit of Fig. 6 is constituted so as to include four p-channel MOS transistors. This is because problems can arise from a two-input NOR gate formed by a mixture of the two p-channel MOS transistors which are mutually connected in series and by two n-channel MOS transistors which are mutually connected in parallel. These problems are as follows. The resistance component at the series connecting portion of the p-channel MOS transistors increases. It takes an undesirably long time for the output voltage of the NOR gate to reach a high level which in turn slows the speed of the logical operation. Consequently, to eliminate such problems, the two-input NOR gate 60 as shown in Fig. 6 is formed using the four p-channel MOS transistors Qp1, Qp1', Qp2, and Qp2' which are respectively included in the individual cell arrays L1 and L2, in the two fundamental cells C1 and C2 which in turn are adjacent to each other in the X direction. The p-channel MOS transistors Qp1 and Qp1' of one fundamental cell C1 are mutually connected in parallel, while the p-channel MOS transistors Qp2 and Qp2' of the other fundamental cell C2 are similarly mutually connected in parallel. These two pairs of p-channel MOS transistor parallel circuits are connected in series. The gate electrodes of the MOS transistors Qp1 and Qp1' and the gate electrodes of the MOS transistors Qp2 and Qp2' serve as the first and second signal input terminals Vin1 and Vin2, respectively.

The connection wiring to be made in the two fundamental cells to obtain the two-input NOR gate serving as one macrocell of Fig. 6 is illustrated in Fig. 4. In Fig. 4, black dots are used to indicate the bonding portions. According to this wiring example, power supply lines 40-1 and 40-2 through which a power supply voltage $V_{SS}$ is supplied are connected to the $n^+$ regions 44a and 52a, respectively. A power supply line 38-1 through which a power supply voltage $V_{DD}$ is supplied is connected to the $p^+$ regions 48a and 48c. Lines 66a and 66b connect the respective gates in the fundamental cells C1 and C2. A line 68 connects the $p^+$ regions 48b and 54b, so that the two MOSFET parallel circuits in the circuit diagram of Fig. 6 are mutually connected in series. A line 70 connects the two $n^+$ regions 44b and 52b to produce the output signal from the macrocell 60 serving as the two-input NOR gate. Two lines 72a and 72b which are connected respectively to the gate electrode patterns 50a and 56a serve as the above-mentioned input terminals $V_{in}1$ and $V_{in}2$. All of these wiring patterns 38, 40, 66, 68, 70, and 72 are necessary to form the 2-input NOR gate 60. They are directly stacked, preferably in three or more layers, over the fundamental cell forming region in the substrate 32, in other words, over the fundamental cell arrays L1, L2, etc. For example, according to the wiring example of Fig. 4, the power supply lines 38 and 40, the wiring lines 66 for wiring the gate electrode patterns 56 in the fundamental cells C1 and C2, and the wiring line 68 are simultaneously formed in a first metal layer (not shown) that is insulatively laminated on the gate electrodes 46, 50 and 56 on the substrate 32. The wiring 70 and 72 which serves as the input/output terminals of the 2-input NOR gate is formed in a second metal layer which is stacked on top of the above-mentioned first metal layer. The wiring pattern which is needed to connect the macrocell 60 with another macrocell (e.g., 80) is formed in a third metal layer which is stacked on top of the above second metal layer.

According to the semiconductor LSI with the CMOS gate-array structure as described above, it is possible to realize a predetermined macrocell which fully utilizes the limited number of CMOS transistors of fundamental cells formed on the substrate, that is without any useless transistors of fundamental cells remaining after personalizing the master chip in order to make an LSI having a desired function. This is because when wiring a plurality of transistors of fundamental cells to create a macrocell, it is permitted to adopt the fundamental cells of one cell array to an adjacent cell array according to the present invention. In other words, when forming one macrocell by a plurality of fundamental cells, it is possible to utilize not only the fundamental cells included in the same cell array but also fundamental cells from a different cell array which is adjacent to the cell array. Thus, the arrangement of the fundamental cells which constitute the macrocell can be freely placed in both the X and Y directions of the substrate 32 in accordance with the situation. For example, according to the macrocell which serves as the 2-input NOR gate consisting of the four p-channel MOSFETs shown in Figs. 4 and 6, the fundamental cells C1 and C2 which are adjacent in the X direction of the cell arrays L1 and L2 were used. According to this wiring example, as indicated by the oblique lines in the cell arrangement diagram illustrated as a model in Fig. 7, the one n-channel MOS transistor Qn1' included in the fundamental cell C1, and the one n-channel MOS transistors Qn2' in the fundamental cell C2 remain as the additional unused transistors. However, these unused MOS transistors Qn1' and Qn2' in the macrocell 60 can be effectively utilized to assemble another macrocell 80 at the next stage. For instance, when constituting a 2-input NAND gate, to prevent an increase in the resistance component to be caused due to the series connecting constitution of the two n-channel MOS transistors, it is preferable to use the four n-channel MOS transistors on the basis of the same considerations of the previously-mentioned NOR gate. In the case of constituting a 2-input NAND gate between the fundamental cells, as shown in Fig. 8, the inside two transistors among the (4 x 2) transistor arrangement remain unused having the same symmetry as the above-described NOR gate. Therefore, if a 2-input NAND gate 80 having such a transistor arrangement is designed at the macrocell at the next stage of the 2-input NOR gate 60, then all transistors can be effectively utilized, that is no transistor will remain unused. Consequently, the cell area necessary to form such two macrocells 60 and 80 can be covered by only the area corresponding to three fundamental cells. As an example for comparison, if two macrocells similar to the above are assembled on a master chip by performing the connection wiring in the conventional gate-array structure shown in Fig. 1, four fundamental cells will be left over. This is because if the fundamental cells in the same cell array are merely sequentially used in the Y direction, the remaining additional transistors in each fundamental cell cannot contribute to make another macrocell at all and so remain unused.

As already described with reference mainly to Fig. 3, in the CMOS cells, which are in different cell arrays and which are adjacent to each other in the X direction, the arrangement sequence of the p-channel FET and the n-channel FET was reversed, thereby eliminating the wiring region which was conventionally inevitable between cell arrays on the substrate 32. Instead, wiring patterns necessary to personalize a general gate-array chip into a dedicated LSI which serves a desired function are formed directly over the cell forming region so as to have a multi-stacked wiring structure of three or more layers. Furthermore, the p-channel MOSFETs (e.g., Qp1 and Qp2, or Qp1' and Qp2' in Figs. 4 and 5), which are in neighboring but different fundamental cells (e.g., C2 and C3) and which are adjacent to each other, commonly use the one n-well region 42. Owing to these devices it is possible to remarkably enhance or improve the integration density of the gate-array LSI (and to also effectively use the transistors in the fundamental cells).

As described above, according to the embodiment of the present invention, the conventional wiring region is eliminated. Instead, the macrocell is constituted by combining fundamental cells in the adjacent cell arrays. In this manner, the degree of freedom of design can be increased, the fundamental cells can be utilized efficiently, and it is also possible to realize the large scale integration of the gate-array.

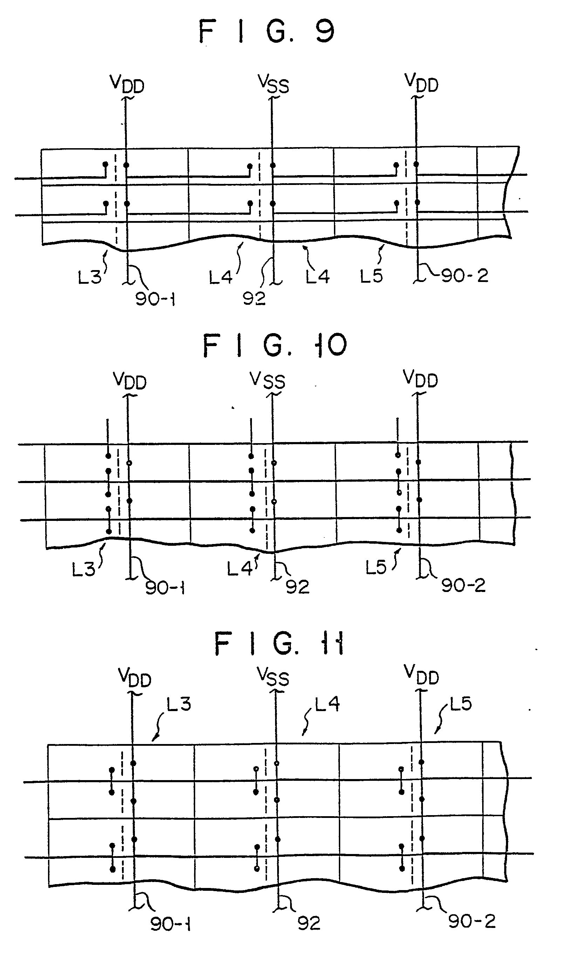

It is possible to further improve the wiring patterns of the power supply lines 38 and 40 among the fundamental cells of a cell array as shown by the cell array L3 in Fig. 3. For instance, as shown in Fig. 9, the line of each cell array is used as the power supply line which runs in the direction of the cell arrays. Namely, power supply lines 90-l, 90-2, etc. on the side of $V_{DD}$ are run in the cell arrays L3, L5, etc. in the direction of cell arrays, while power supply lines 92, etc. on the side of $V_{SS}$ are run in the cell arrays L4, etc. which are symmetrical to the cell arrays L3, etc. with respect to the left and right of the cell arrays. Through branch wires which leave power supply lines 90 and 92 in the transverse direction, power is supplied to the necessary fundamental cells which are adjacent to the cell arrays. Fig. 10 shows a further modification of Fig. 9, in which the same branch wires are wired to the boundaries of the fundamental cells adjacent to the upper and lower portions of the cell arrays, thereby simultaneously supplying power to the upper and lower fundamental cells. As a further development of this, as shown in Fig. 11, it is also possible to reduce the number of branch wires to be led out transversely by half.

In addition, although an example of a CMOS of the n-well method has been mainly shown in the above description, the present invention can be also similarly applied to the case where the CMOSs of the p-well method and the twin-tub method are used.

## Claims

l. A CMOS gate-array type integrated circuit device having a plurality of cell arrays (L1, L2, ...) disposed along a row direction (X) on a semiconductive substrate (32), each of which cell arrays includes a plurality of fundamental cells (C1, C2, ...) of CMOS construction linearly aligned in a column direction (Y), wherein at least one fundamental cell is used to form each of a plurality of macrocells (60, 80) which serves as unit logical circuit components of an integrated circuit having a desired function, which circuit is constituted by suitably wiring said logical circuit components and providing power source lines ($V_{DD}$, $V_{SS}$), characterized in that:at least one arbitrary fundamental cell array among said plurality of cell arrays (L1, L2, ...) is in direct contact with other fundamental cell arrays which are adjacent to each other along the row direction (X), so as to include MOS type transistors (Qp1, Qp2) of the same channel type which are in contact with each other in the row direction (X), which commonly use a semiconductive well region (42) having the opposite conductivity type to that of said substrate (32) and being formed on the surface portion of said substrate (32), and which respectively belong to the two different cell arrays (L1, L2) which are adjacent to each other; and in that said macrocells include at least one macrocell (60) which is constituted so as to have a particular logical function by at least the two fundamental cells (C1, C2) which are respectively included in the two mutually neighboring cell arrays (L1, L2) and which are adjacent to each other along the row direction (X) and which are directly coupled.

2. The device as recited in claim 1, characterized in that first electrical connecting means (66, 68, 70) is provided for adding predetermined connection wiring patterns to at least the two fundamental cells (C1, C2) which are respectively included in said two mutually neighboring fundamental cell arrays (L1, L2, ...) and which are adjacent to each other along the column direction (Y) and which are directly coupled, thereby forming at least said one macrocell (60) having a particular logical function in said fundamental cell arrays.

3. The device as recited in claim 2, characterized in that second electrical connecting means (72) is provided for suitably wiring said plurality of macrocells, thereby forming said desired integrated circuit.

4. The device as recited in claim 3, characterized in that third electrical connecting means (28, 40) is provided for supplying a necessary power source to said fundamental cells (C1, C2, ...) which constitute said plurality of macrocells (60, 80).

5. The device as recited in claim 4, characterized in that said first, second and third electrical connecting means (38, 40, 66, 68, 70, 72) are mutually stacked over said plurality of fundamental cell arrays (L1, L2, ...).

6. The device as recited in claim 5, characterized in that said fundamental cells (C) are electrically connected in such a manner as to eliminate the presence of the excess MOS type transistors of the fundamental cells in at least two macrocells (60, 80) among said plurality of macrocells.

7. The device as recited in claim 6, characterized in that at least said two macrocells (60, 80) correspond to a NOR gate and a NAND gate, respectively.

**Patentansprüche**

1. Integrierte CMOS-Schaltungsvorrichtung mit Gatteranordnungsstruktur, mit einer Vielzahl von entlang einer Zeilenrichtung (X) auf einem Halbleitersubstrat (32) vorgesehenen Zellenanordnungen (L1, L2, ...), deren jede eine Vielzahl von Grundzellen (C1, C2, ...) von CMOS Aufbau hat, welche linear in einer Spaltenrichtung (Y) vorgesehen sind, wobei wenigstens eine Grundzelle verwendet wird, um jede einer Vielzahl von Makrozellen (60, 80) zu bilden, die als Einheitslogikschaltungskomponenten einer eine gewünschte Funktion aufweisenden integrierten Schaltung dient, welche durch geeignetes Verdrahten der Logikschaltungskomponenten und Vorsehen von Spannungsquellenleitungen ($V_{DD}$, $V_{SS}$) gebildet ist, dadurch gekennzeichnet, daß wenigstens eine beliebige Grundzellenanordnung unter der Vielzahl von Zellenanordnungen (L1, L2, ...) in direktem Kontakt mit anderen Grundzellenanordnungen ist, welche nebeneinander entlang der Zeilenrichtung (X) liegen, um so MOS-Transistoren (Qp1, Qp2) des gleichen Kanaltyps zu umfassen, welche miteinander in Kontakt in der Zeilenrichtung (X) sind, welche gemeinsam einen Halbleiterschutzbereich (42) benutzen, der den entgegengesetzten Leitfähigkeitstyp zu demjenigen des Substrates (32) hat und auf dem Oberflächenteil des Substrats (32) ausgeführt ist, und welche jeweils zu den beiden verschiedenen Zellenanordnungen (L1, L2) gehören, die nebeneinander angeordnet sind, und daß die Makrozellen wenigstens eine Makrozelle (60) umfassen, die so gebildet ist, daß sie eine besondere Logikfunktion durch wenigstens die zwei Grundzellen (C1, C2) hat, die jeweils in den beiden wechselseitig benachbarten Zellenanordnungen (L1, L2) eingeschlossen sind und die nebeneinander zueinander in der Zeilenrichtung (X) liegen und direkt gekoppelt sind.

2. Vorrichtung nach Anspruch 1, dadurch gekennzeichnet, daß eine erste elektrische Verbindungseinrichtung (66, 68, 70) vorgesehen ist, um vorbestimmte Verbindungsverdrahtungsmuster zu wenigstens den beiden Grundzellen (C1, C2) beizufügen, die jeweils in den beiden wechselseitig benachbarten Grundzellenanordnungen (L1, L2, ...) enthalten sind und die nebeneinander zueinander entlang der Spaltenrichtung (Y) liegen und direkt gekoppelt sind, um so wenigstens die eine Makrozelle (60) mit einer besonderen Logikfunktion in den Grundzellenanordnungen zu bilden.

3. Vorrichtung nach Anspruch 2, dadurch gekennzeichnet, daß eine zweite elektrische Verbindungseinrichtung (32) vorgesehen ist, um geeignet die Vielzahl von Makrozellen zu verdrahten, wodurch so die gewünschte integrierte Schaltung gebildet wird.

4. Vorrichtung nach Anspruch 3, dadurch gekennzeichnet, daß eine dritte elektrische Verbindungseinrichtung (28, 40) vorgesehen ist, um eine notwendige Strom- bzw. Spannungsquelle an die Grundzellen (C1, C2, ...) zu legen, die die Vielzahl von Makrozellen (60, 80) bilden.

5. Vorrichtung nach Anspruch 4, dadurch gekennzeichnet, daß die ersten, zweiten und dritten elektrischen Verbindungseinrichtungen (38, 40, 66, 68, 70, 72) wechselseitig über die Vielzahl von Grundzellenanordnungen (L1, L2, ...) gestapelt sind.

6. Vorrichtung nach Anspruch 5, dadurch gekennzeichnet, daß die Grundzellen (C) elektrisch derart verbunden sind, daß das Vorliegen von den überschüssigen MOS-Transistoren in den Grundzellen in wenigstens zwei Makrozellen (60, 80) unter der Vielzahl von Makrozellen ausgeschlossen ist.

7. Vorrichtung nach Anspruch 6, dadurch gekennzeichnet, daß wenigstens die zwei Makrozellen (60, 80) einem NOR-Gatter bzw. einem NAND-Gatter entsprechen.

**Revendications**

1. Dispositif de circuit intégré du type à rangées de portes CMOS ayant une pluralité de rangées de cellules (L1, L2, ...) disposées suivant une direction de ligne (X) sur un substrat semiconducteur (32), chacune de ces rangées de cellules comprenant une pluralité de cellules fondamentales (C1, C2, ...) de construction CMOS alignées linéairement dans une direction de colonne (Y), dans lequel au moins une cellule fondamentale est utilisée pour former chaque macrocellule d'une pluralité de macrocellules (60, 80) qui servent de composants unitaires de circuit logique d'un circuit intégré ayant une fonction souhaitée, lequel circuit est constitué en câblant de façon appropriée lesdits composants de circuit logique et en prévoyant des lignes ($V_{DD}$, $V_{SS}$) de source d'alimentation, caractérisé en ce qu'une rangée de cellules fondamentales arbitraire parmi ladite pluralité de rangées de cellules (L1, L2, ...) est en contact direct avec d'autres rangées de cellules fondamentales qui sont adjacentes les unes aux autres dans la direction de ligne (X), de façon à inclure des transistors de type MOS (Qp1, Qp2) du même type de canal qui sont en contact l'un avec l'autre dans la direction de ligne (X), qui utilisent habituellement une région de puits (42) semiconductrice ayant le type de conductivité opposé à celui dudit substrat (32) et étant formée sur la partie de surface dudit substrat (32), et qui appartiennent respectivement aux deux rangées de cellules différentes (L1, L2) qui sont adjacentes l'une à l'autre; et en ce que lesdites macrocellules comprennent au moins une macrocellule (60) qui est constituée de façon à avoir une fonction logique particulière par au moins les deux cellules fondamentales (C1, C2) qui sont incluses respectivement dans les deux rangées de cellules mutuellement voisines (L1, L2) et qui sont adjacentes l'une à l'autre dans la direction de ligne (X) et qui sont directement couplées.

2. Dispositif selon la revendication 1, caractérisé en ce qu'un premier moyen de branchement électrique (66, 68, 70) est prévu pour ajouter des motifs de câblage de branchement prédéterminés à au moins les deux cellules fondamentales (C1, C2) qui sont incluses respectivement dans lesdites deux rangées de cellules fondamentales mutuellement voisines (L1, L2, ...) et qui sont adjacentes l'une à l'autre dans la direction de colonne (Y) et qui sont directement couplées, formant ainsi au moins une macrocellule (60) qui a une fonction logique particulière dans lesdites rangées de cellules fondamentales.

3. Dispositif selon la revendication 2, caractérisé en ce qu'un second moyen de branchement électrique (72) est prévu pour câbler convenablement ladite pluralité de macrocellules, formant ainsi ledit circuit intégré souhaité.

4. Dispositif selon la revendication 3, caractérisé en ce qu'un troisième moyen de branchement électrique (28, 40) est prévu pour fournir une source d'alimentation nécessaire auxdites cellules fondamentales (C1, C2, ...) qui constituent ladite pluralité de macrocellules (60, 80).

5. Dispositif selon la revendication 4, caractérisé en ce que lesdits premier, second et troisième moyens de branchement électrique (38, 40, 66, 68, 70, 72) sont mutuellement empilés au-dessus de ladite pluralité de rangées de cellules fondamentales (L1, L2, ...).

6. Dispositif selon la revendication 5, caractérisé en ce que lesdites cellules fondamentales (C) sont branchées électriquement de façon à éliminer la présence des transistors de type MOS en excès des cellules fondamentales dans au moins deux macrocellules (60, 80) parmi ladite pluralité de macrocellules.

7. Dispositif selon la revendication 6, caractérisé en ce qu'au moins les deux macrocellules (60, 80) correspondent à une porte NOR et à une porte NAND, respectivement.

# F I G. 1

# F I G. 2

# F I G. 3

# F I G. 4

# F I G. 5

0 119 059

# F I G. 6

# F I G. 7

# F I G. 8

4

# F I G. 9

# F I G. 10

# F I G. 11